# EUROPÄISCHE PATENTSCHRIFT

(11) **EP 4 288 788 B1**
(45) Veröffentlichungstag und Bekanntmachung des Hinweises auf die Patenterteilung: **28.08.2024**
(21) Anmeldenummer: 22822516.5
(22) Anmeldetag: 28.11.2022
(51) Int. Cl.: G01R 31/367, G01R 31/382, H02J 7/00, B60W 40/12, B60W 50/00

(54) **VERFAHREN ZUR PROGNOSTIZIERUNG DES ENERGIEBEDARFS EINES KRAFTFAHRZEUGS**
METHOD FOR FORECASTING THE ENERGY REQUIREMENT OF A MOTOR VEHICLE
PROCÉDÉ DE PRÉVISION DE L'EXIGENCE ÉNERGÉTIQUE D'UN VÉHICULE AUTOMOBILE

(30) Priorität: 21.12.2021 DE 102021006280
(43) Veröffentlichungstag der Anmeldung: 13.12.2023
(73) Patentinhaber: Mercedes-Benz Group AG, 70372 Stuttgart (DE)
(72) Erfinder: BRAUNEIS, Daniel, 94036 Passau (DE); MÜLLER, Julian, 75392 Deckenpfronn (DE); LINDBÜCHL, Roland, 71034 Böblingen (DE); KÖNIG, Simone, 73486 Adelmannsfelden (DE)
(74) Vertreter: Novagraaf Group
(86) Internationale Anmeldenummer: PCT/EP2022/083499
(87) Internationale Veröffentlichungsnummer: WO 2023/117318

(56) Entgegenhaltungen:
- WO-A1-2019/017991
- CN-A- 101 519 073
- CN-U- 203 405 557
- DE-A1- 102013 109 348
- DE-U1- 202015 106 567
- US-A1- 2016 358 475
- US-A1- 2021 116 907

## Beschreibung

Die Erfindung betrifft ein Verfahren zur Prognostizierung des Energiebedarfs eines Kraftfahrzeugs gemäß dem Oberbegriff des Anspruchs 1.

Ein Verfahren der eingangs genannten Art ist aus der US 2021/116907 A1 bekannt. Ein weiteres Verfahren zur Prognostizierung des Energiebedarfs ist aus DE 20 2018 106 059 U1 bekannt. Es lehrt insbesondere ein System zur Erfassung des elektrischen Leistungsbedarfs von Busteilnehmern eines Bussystems im Bereich der Gebäudetechnik. Weiterhin wird auf die Schriften DE 10 2013 109348 A1, DE 20 2015 106567 U1, US 2016/358475 A1, CN 203 405 557 U, CN 101 519 073 A sowie WO 2019/017991 A1 hingewiesen.

Die Aufgabe der Erfindung liegt darin, ein verbessertes oder zumindest ein anderes Verfahren zur Prognostizierung des Energiebedarfs bereitzustellen oder anzugeben.

Bei der vorliegenden Erfindung wird diese Aufgabe insbesondere durch den Gegenstand des unabhängigen Anspruchs 1 gelöst. Vorteilhafte Ausführungsformen sind Gegenstand der abhängigen Ansprüche und der Beschreibung.

Der Kerngedanke der Erfindung liegt darin, an einem beispielsweise im Rahmen der Kraftfahrzeugentwicklung genutzten Kraftfahrzeugmodell eines Kraftfahrzeugtyps Strombedarfs- und Bus-Daten zu erfassen und diese an einer künstlichen Intelligenz bereitzustellen, die dadurch in der Lage ist, ein sogenanntes künstliches Funktionsmodell zu generieren und/oder zu trainieren. Ein demgemäß generiertes und/oder trainiertes künstliches Funktionsmodell kann demnach werkseitig vorbereitet werden, um dann in einem marktreifen Kraftfahrzeug diesen Kraftfahrzeugtyps oder eines ähnlichen Kraftfahrzeugtyps integriert oder in ein Steuergerät des Kraftfahrzeugs implementiert zu werden. Um einem Nutzer des Kraftfahrzeugs eine Prognose zum Energiebedarf des Kraftfahrzeugs anbieten zu können, werden gemäß der Erfindung dann lediglich noch am Kraftfahrzeug erfasste Bus-Daten an dem künstlichen Funktionsmodell bereitgestellt, welches dieselben in eine entsprechende Prognose zum Energiebedarf des Kraftfahrzeugs übersetzt.

Hierzu schlägt die Erfindung ein Verfahren zur Prognostizierung des Energiebedarfs eines Kraftfahrzeugs vor, in dessen Rahmen die folgenden Schritte ausgeführt werden:
1) Generieren und/oder Trainieren eines künstlichen Funktionsmodells mittels einer nachfolgend als KI bezeichneten künstliche Intelligenz eines Kraftfahrzeugmodells, indem das Kraftfahrzeugmodell mit an Stromsicherungen oder an einem elektrischen Verbraucher des Kraftfahrzeugmodells angeordneten Messsensoren zum Erfassen des Strombedarfs jeder Stromsicherung des Kraftfahrzeugmodells sowie mit mindestens einem an einem Datenbus des Kraftfahrzeugmodells angeordneten Datenaufzeichner zum Erfassen von über den Datenbus ausgetauschten Bus-Daten bereitgestellt wird. Sodann kann mittels der Messsensoren ein Strombedarf an jeder Stromsicherung erfasst und diesen Strombedarf repräsentierende Strombedarfs-Daten bereitgestellt werden, wobei mittels dem mindestens einen Datenaufzeichner Bus-Daten erfasst und bereitgestellt werden. Die ermittelten Bus-Daten und Strombedarfs-Daten werden dann in einem Speicher, insbesondere ein Speicher des Kraftfahrzeugmodells und/oder eines Kraftfahrzeugs, gespeichert und synchronisiert. Anschließend können dann die gespeicherten, synchronisierten Bus-Daten und Strombedarfs-Daten als sogenannte Trainingsdaten an der besagten KI des Kraftfahrzeugmodells bereitgestellt werden, wobei die Kl anhand der bereitgestellten Bus-Daten und Strombedarfs-Daten ein künstliches Funktionsmodell generiert und/oder trainiert. Das künstliche Funktionsmodell repräsentiert dabei oder dadurch eine Korrelation zwischen den Bus-Daten und den Strombedarfs-Daten. In einem sich anschließenden Schritt 2) ist vorgesehen, dass der Energiebedarf eines Kraftfahrzeugs prognostiziert wird, indem es mit mindestens einem an einem Datenbus des Kraftfahrzeugs angeordneten Datenaufzeichner zum Erfassen von über den Datenbus des Kraftfahrzeugs ausgetauschten Bus-Daten bereitgestellt wird, mittels dem mindestens einen Datenaufzeichner des Kraftfahrzeugs Bus-Daten des Kraftfahrzeugs erfasst und bereitgestellt werden, wobei ein gemäß Schritt 1) generiertes und/oder trainiertes künstliches Funktionsmodell am Kraftfahrzeug bereitgestellt und mit den erfassten Bus-Daten des Kraftfahrzeugs versorgt wird. Dadurch kann das künstliche Funktionsmodell (nachfolgend als PGS-Daten bezeichnete) Prognostizierte-Gesamt-Strombedarf-Daten bereitstellen, welche den prognostizierten Gesamt-Strombedarf des Kraftfahrzeugs oder den prognostizierten Strombedarf einzelner Stromsicherungen und/oder elektrischer Verbraucher des Kraftfahrzeugs repräsentieren.

Mit anderen Worten schlägt das erfindungsgemäße Verfahren vor, in einem Schritt 1) zunächst ein künstliches Funktionsmodell mittels einer KI zu generieren und/oder zu trainieren, wobei Daten eines Kraftfahrzeugmodells eines vorgegebenen Kraftfahrzeugtyps genutzt werden. Schritt 1) des erfindungsgemäßen Verfahrens kann daher bevorzugt im Rahmen der Entwicklung des Kraftfahrzeugtyps vor Ort beim Hersteller ausgeführt werden. Gemäß Schritt 2) wird das herstellerseitig generierte und/oder trainierte künstliche Funktionsmodell an einem Kraftfahrzeug dieses Kraftfahrzeugtyps oder eines ähnlichen Kraftfahrzeugtyps bereitgestellt, beispielsweise kabellos via Funk oder kabelgebunden im Rahmen eines Kraftfahrzeug-Services in einer Werkstatt oder weiter beispielsweise kabelgebunden oder via Funk bereits während der Produktion im Rahmen der Serienausstattung des Kraftfahrzeugs. Im Rahmen von Schritt 2) kann dann mittels am jeweiligen Kraftfahrzeug erfassten Bus-Daten und des bereitgestellten künstlichen Funktionsmodells ein Gesamt-Strombedarf des Kraftfahrzeugs prognostiziert werden, indem das künstliche Funktionsmodell dieselben in eine entsprechende Prognose zum Energiebedarf des Kraftfahrzeugs übersetzt. Vorteilhafterweise kann insbesondere der Strombedarf einzelner Systeme und/oder Komponenten des Kraftfahrzeugs prognostiziert werden.

Die Erfindung versteht unter dem Ausdruck "Evaluierung des Energiebedarfs" zweckmäßigerweise die Annäherung oder Abschätzung des Energiebedarfs des Kraftfahrzeugs. Ferner versteht die Erfindung unter dem Begriff "bereitstellen" insbesondere eine Integration und/oder eine Implementierung.

Erfindungsgemäß ist weiterhin vorgesehen, dass die ermittelten Bus-Daten während der Generierung und/oder des Trainierens der Kl gemäß Schritt 1) und/oder während der Prognostizierung des Energiebedarfs eines Kraftfahrzeugs gemäß Schritt 2) dazu genutzt werden, das künstliche Funktionsmodell zu verbessern. Dadurch kann ein sogenanntes tiefes Verstärkungslernen (aus dem englischen "Deep Reinforcement Learning") realisiert werden, d.h. das in einem Kraftfahrzeugmodell und/oder einem Kraftfahrzeug installierte künstliche Funktionsmodell wird kontinuierlich trainiert und/oder angepasst. Dadurch ist es dem künstlichen Funktionsmodell beispielsweise möglich, auf Fahrstile unterschiedlicher Nutzer des Kraftfahrzeugmodells und/oder eines Kraftfahrzeugs zu reagieren, wodurch ein prognostizierter Energiebedarf des Kraftfahrzeugmodells und/oder eines Kraftfahrzeugs individuell anpassbar oder kalkulierbar oder berechenbar oder annäherbar ist.

Um die besagte Verbesserung des künstlichen Funktionsmodells durchführen zu können, ist weiterhin erfindungsgemäß vorgesehen, dass die ermittelten Bus-Daten Gesamt-Strombedarf-Daten aufweisen, welche nachfolgend einfachheitshalber als GS-Daten bezeichnet werden. Sie repräsentieren den tatsächlichen Gesamt-Strombedarf des Kraftfahrzeugs. Mittels dem künstlichen Funktionsmodell werden dann die besagten PGS-Daten bereitgestellt, die den prognostizierten Gesamt-Strombedarf des Kraftfahrzeugs repräsentieren, wobei die GS-Daten mit den PGS-Daten verglichen werden, beispielsweise in einem Vergleicher des Kraftfahrzeugs oder des künstlichen Funktionsmodells. Das künstliche Funktionsmodell ist hierbei dazu eingerichtet, eine Abweichung zwischen den GS-Daten und den PGS-Daten zu ermitteln, also eine Abweichung zwischen dem tatsächlichen Gesamt-Strombedarf des Kraftfahrzeugs und dem prognostizierten Gesamt-Strombedarf des Kraftfahrzeugs. Das künstliche Funktionsmodell ist weiterhin dazu eingerichtet, diese ermittelte Abweichung zu beeinflussen, nämlich zu minimieren. Um die angestrebte Verbesserung des künstlichen Funktionsmodells zu realisieren, veranlasst das künstliche Funktionsmodell, dass eine Minimierung der Abweichung zwischen den GS-Daten und den PGS-Daten realisiert wird, wenn die GS-Daten von den PGS-Daten abweichen. Dadurch wird bei der Kl ein verbesserter Lerneffekt erzielt. Das hat insbesondere den Vorteil, dass beispielsweise bei einer gegebenen Restkapazität eines Energiespeichers des Kraftfahrzeugs eine verbleibende Reichweite des Kraftfahrzeugs besser prognostizierbar ist. Zudem kann die Kl aufgrund des vorherigen Fahrverhaltens und der Nutzung einzelner Systeme des Kraftfahrzeugs während der Fahrt den Energiebedarf einzelner Komponenten des Kraftfahrzeugs genauer abschätzen, wodurch eine relativ genaue Prognose der Restreichweite des Kraftfahrzeugs ermöglicht wird. Weiterhin können einem Nutzer des Kraftfahrzeugs gezielt Vorschläge zur Energieeinsparung gemacht werden, beispielsweise, dass bestimmte Verbraucher des Kraftfahrzeugs deaktiviert werden, um die Restreichweite desselben zu erhöhen. Zudem ist vorstellbar, dass weitere Verbraucher des Kraftfahrzeugs automatisch basierend auf der aktuellen Prognose der Kl beispielsweise durch ein Steuergerät des Kraftfahrzeugs gesteuert oder geregelt werden. Weiter zweckmäßigerweise werden die PGS-Daten an einem Steuergerät des Kraftfahrzeugs bereitgestellt und/oder dort verwendet. Zweckmäßigerweise kann auch die Kl und/oder das künstliche Funktionsmodell an einem Steuergerät des Kraftfahrzeugs bereitgestellt und/oder dort integriert sein. Dadurch ist das erfindungsgemäße Verfahren leicht und kostengünstig an einem Kraftfahrzeug bereitstellbar.

Zweckmäßigerweise wird das besagte künstliche Funktionsmodell bevorzugt in Kraftfahrzeugen eines einzigen Kraftfahrzeugtyps und/oder einer Entwicklungsumgebung verwendet. Das besagte künstliche Funktionsmodell kann jedoch, wie bereits angedeutet, auch für Kraftfahrzeuge eines ähnlichen oder gänzlich fremden Kraftfahrzeugtyps genutzt werden. Dadurch kann das künstliche Funktionsmodell sozusagen typübergreifend eingesetzt werden, um Abschätzungen des Energiebedarfs einzelner Kraftfahrzeuge bereitzustellen. Dadurch kann das vorgeschlagene künstliche Funktionsmodell relativ kostengünstig eingesetzt werden.

Weiter zweckmäßigerweise werden die PGS-Daten eines Kraftfahrzeugs an einem Backend, insbesondere eine vom Kraftfahrzeug entfernte stationäre Stelle, beispielsweise ein Server, bereitgestellt und/oder dort verwendet. Dadurch kann der Energiebedarf einer Gruppe von Kraftfahrzeugen eines Kraftfahrzeugtyps von extern erfasst und überwacht werden.

Zweckmäßigerweise kann vorgesehen sein, dass das besagte künstliche Funktionsmodell durch ein künstliches neuronales Netz oder ein Regressionsmodell oder ein alternatives Machine-Learning-Modell realisiert ist. Dadurch sind mehrere vorteilhafte künstliche Funktionsmodelle angegeben. Es versteht sich von selbst, dass zweckmäßigerweise weitere und vorzugsweise sämtliche Klassen, Typen und Methoden von künstlichen Funktionsmodellen und/oder künstlichen neuronalen Netz mit umfasst sein können.

Zusammenfassend bleibt festzuhalten: Die Erfindung betrifft zweckmäßigerweise ein Verfahren zur Prognostizierung des Energiebedarfs eines Kraftfahrzeugs. Wesentlich ist, dass ein künstliches Funktionsmodell mittels einer als KI bezeichneten künstlichen Intelligenz eines Kraftfahrzeugmodells generiert und/oder trainiert wird und dass in einem sich anschließenden Schritt der Energiebedarf eines Kraftfahrzeugs prognostiziert wird, indem mindestens ein an einem Datenbus des Kraftfahrzeugs angeordneter Datenaufzeichner zum Erfassen von über den Datenbus ausgetauschten Bus-Daten bereitgestellt wird, wobei mittels dem mindestens einen Datenaufzeichner Bus-Daten erfasst werden, wobei ein zuvor gemäß dem Verfahren generiertes und/oder trainiertes künstliches Funktionsmodell am Kraftfahrzeug bereitgestellt und mit den erfassten Bus-Daten des Kraftfahrzeugs versorgt wird, wobei das künstliche Funktionsmodell dann Prognostizierte-Gesamt-Strombedarf-Daten bereitstellt, die den prognostizierten Gesamt-Strombedarf des Kraftfahrzeugs oder den prognostizierten Strombedarf einzelner Komponenten des Kraftfahrzeugs repräsentieren.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ein bevorzugtes Ausführungsbeispiel der Erfindung ist in den Zeichnungen dargestellt und in der nachfolgenden Beschreibung näher erläutert, wobei sich gleiche Bezugszeichen auf gleiche oder ähnliche oder funktional gleiche Bauteile beziehen.

Dabei zeigen jeweils schematisch:
- Fig. 1: in einem Ablaufdiagramm das Generieren und/oder Trainieren eines künstlichen Funktionsmodells gemäß einem bevorzugten Ausführungsbeispiel des erfindungsgemäßen Verfahrens,
- Fig. 2: in einem weiteren Ablaufdiagramm die Prognostizierung des Energiebedarfs eines Kraftfahrzeugs gemäß einem bevorzugten Ausführungsbeispiel des erfindungsgemäßen Verfahrens und zuletzt
- Fig. 3: in einem weiteren Ablaufdiagramm ein sogenanntes tiefes Verstärkungslernen (aus dem englischen "Deep Reinforcement Learning") mit einem künstlichen Funktionsmodell gemäß einem bevorzugten Ausführungsbeispiel des erfindungsgemäßen Verfahrens.

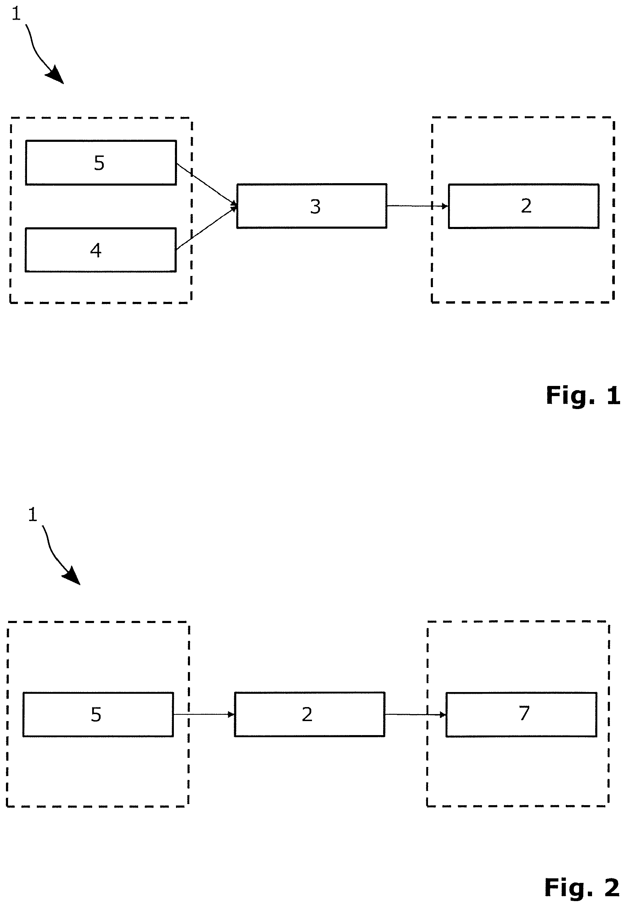

Die Fig. 1 zeigt in einem Ablaufdiagramm das Generieren und/oder Trainieren eines künstlichen Funktionsmodells 2 gemäß einem bevorzugten Ausführungsbeispiel des erfindungsgemäßen Verfahrens 1 zur Prognostizierung des Energiebedarfs eines nicht illustrierten Kraftfahrzeugmodells. Das illustrierte Verfahren 1 umfasst einen Schritt 1) gemäß dem mittels einer nachfolgend als KI bezeichneten künstliche Intelligenz 3 des Kraftfahrzeugmodells ein durch ein Kästchen symbolisiertes künstliches Funktionsmodell 2 generiert und/oder trainiert wird. Hierzu ist vorgesehen, dass das Kraftfahrzeugmodell mit an Stromsicherungen des Kraftfahrzeugmodells angeordneten Messsensoren zum Erfassen eines Strombedarfs jeder Stromsicherung des Kraftfahrzeugmodells und zum Bereitstellen von den erfassten Strombedarf repräsentierenden Strombedarfs-Daten 4 sowie mit mindestens einem an einem Datenbus des Kraftfahrzeugmodells angeordneten Datenaufzeichner zum Erfassen von über den Datenbus ausgetauschten Bus-Daten 5 bereitgestellt wird. Im Rahmen des Verfahrens 1 werden mittels den Messsensoren dann ein Strombedarf an jeder Stromsicherung erfasst sowie weiterhin Strombedarfs-Daten 4 bereitgestellt, welche diese erfassten Strombedarfe repräsentieren. Im Rahmen des Verfahrens 1 werden weiterhin mittels dem mindestens einen Datenaufzeichner Bus-Daten 5 erfasst und bereitgestellt. Die Bus-Daten 5 und Strombedarfs-Daten 4 werden dann in einem nicht illustrierten Speicher gespeichert und zeitsynchronisiert, insbesondere in der Art, dass den einzelnen Bus-Daten 5 in zeitlicher Hinsicht korrelierenden Strombedarfs-Daten 4 zugeordnet werden. In Fig. 1 sind sowohl die Strombedarfs-Daten 4 als auch die Bus-Daten 5 durch ein einfaches Kästchen symbolisiert. Um das besagte künstliche Funktionsmodell 2 zu generieren und/oder zu trainieren ist weiterhin vorgesehen, dass die gespeicherten, zeitsynchronisierten Bus-Daten 5 und Strombedarfs-Daten 4 als sogenannte Trainingsdaten an der besagten Kl 3 des Kraftfahrzeugmodells bereitgestellt und verarbeitet werden, in der Art, dass die Kl 3 als Ergebnis anhand der bereitgestellten Bus-Daten 5 und Strombedarfs-Daten 4 das künstliche Funktionsmodell 2 generieren und/oder trainieren kann.

Die Fig. 2 zeigt in einem weiteren Ablaufdiagramm die Prognostizierung des Energiebedarfs eines nicht illustrierten, marktreifen Kraftfahrzeugs gemäß einem bevorzugten Ausführungsbeispiel des erfindungsgemäßen Verfahrens 1. Das illustrierte Verfahren 1 umfasst zweckmäßigerweise einen Schritt 2), gemäß dem der Energiebedarf des Kraftfahrzeugs prognostizierbar ist, indem das Kraftfahrzeug zunächst mit mindestens einem an einem Datenbus des Kraftfahrzeugs angeordneten Datenaufzeichner zum Erfassen von über den Datenbus des Kraftfahrzeugs ausgetauschten Bus-Daten 5 bereitgestellt wird. Im Rahmen von Schritt 2) des Verfahrens 1 ist dann vorgesehen, dass mittels dem mindestens einen Datenaufzeichner des Kraftfahrzeugs im tatsächlichen Betrieb des Kraftfahrzeugs Bus-Daten 5 des Kraftfahrzeugs erfasst und bereitgestellt werden. Ein im Rahmen von Schritt 1) des Verfahrens 1 vorab generiertes und/oder trainiertes künstliches Funktionsmodell 2, welches ebenfalls am Kraftfahrzeug bereitgestellt wird, kann nun mit den erfassten Bus-Daten 5 versorgt werden, so dass es dann, nachfolgend als PGS-Daten bezeichnete Prognostizierte-Gesamt-Strombedarf-Daten 7 ermittelt und bereitstellt. Diese PGS-Daten 7 repräsentieren den prognostizierten Gesamt-Strombedarf des Kraftfahrzeugs oder den prognostizierten Strombedarf einzelner Stromsicherungen des Kraftfahrzeugs.

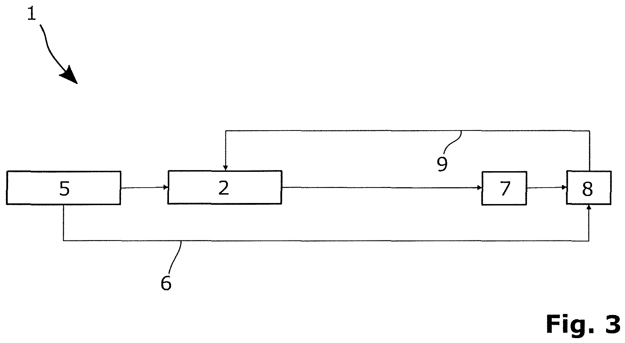

In Fig. 3 ist anhand einem weiteren Ablaufdiagramm ein sogenanntes tiefes Verstärkungslernen (aus dem englischen "Deep Reinforcement Learning") mit einem künstlichen Funktionsmodell 2 gemäß einem bevorzugten Ausführungsbeispiel des erfindungsgemäßen Verfahrens 1 gezeigt. Hierbei ist vorgesehen, dass die gemäß Schritt 1) und/oder 2) des erfindungsgemäßen Verfahrens 1 ermittelten Bus-Daten 5 dazu genutzt werden, das vorab gemäß Schritt 1) und/oder 2) des erfindungsgemäßen Verfahrens 1 an einem Kraftfahrzeugmodell und/oder an einem Kraftfahrzeug bereitgestellte künstliche Funktionsmodell 2 zu trainieren oder zumindest anzupassen oder zu optimieren. Hierzu ist exemplarisch vorgesehen, dass die ermittelten Bus-Daten 5 als GS-Daten bezeichnete Gesamt-Strombedarf-Daten 6 aufweisen oder umfassen, die den tatsächlichen Gesamt-Strombedarf des Kraftfahrzeugmodells oder des Kraftfahrzeugs repräsentieren und dass mittels dem künstlichen Funktionsmodell 2 PGS-Daten 7 bereitgestellt werden, die - wie erwähnt - den prognostizierten Gesamt-Strombedarf des Kraftfahrzeugmodells und/oder des Kraftfahrzeugs repräsentieren. Anschließend werden die GS-Daten 6 mit den PGS-Daten 7 in einem Vergleicher 8 verglichen. Exemplarisch ist das künstliche Funktionsmodell 2 dazu eingerichtet, eine Abweichung 9 zwischen den GS-Daten 6 und den PGS-Daten 7 zu minimieren, insbesondere indem eine ermittelte Abweichung 9 vom Vergleicher 8 zum künstlichen Funktionsmodell 2 zurückgeführt wird. Das tiefe Verstärkungslernen wird dann insbesondere dadurch erreicht, dass das künstliche Funktionsmodell 2 eine Minimierung einer ermittelten Abweichung 9 zwischen den GS-Daten 6 und den PGS-Daten 7 veranlasst, wenn die GS-Daten 6 von den PGS-Daten 7 tatsächlich abweichen.

## Patentansprüche

1. Verfahren (1) zur Prognostizierung des Energiebedarfs eines Kraftfahrzeugs, mit folgenden Schritten:
1) Generieren und/oder Trainieren eines künstlichen Funktionsmodells (2) mittels einer nachfolgend als KI bezeichneten künstliche Intelligenz (3) eines Kraftfahrzeugmodells, indem
- das Kraftfahrzeugmodell mit an Stromsicherungen des Kraftfahrzeugmodells angeordneten Messsensoren zum Erfassen eines Strombedarfs derselben und zum Bereitstellen von den erfassten Strombedarf repräsentierenden Strombedarfs-Daten (4) sowie mit mindestens einem an einem Datenbus des Kraftfahrzeugmodells angeordneten Datenaufzeichner zum Erfassen von über denselben kommunizierten Bus-Daten (5) bereitgestellt wird,
- mittels der Messsensoren ein Strombedarf an einer Stromsicherung erfasst oder an einem elektrischen Verbraucher und diesen erfassten Strombedarf repräsentierende Strombedarfs-Daten (4) bereitgestellt werden,
- mittels dem mindestens einen Datenaufzeichner Bus-Daten (5) erfasst und bereitgestellt werden,
- wobei dann die Bus-Daten (5) und Strombedarfs-Daten (4) zeitsynchronisiert und in einem Speicher als Trainingsdaten gespeichert werden,
- wobei dann diese Trainingsdaten an der besagten Kl (3) des Kraftfahrzeugmodells bereitgestellt werden,
- wobei die Kl (3) anhand der bereitgestellten Bus-Daten (5) und Strombedarfs-Daten (4) ein künstliches Funktionsmodell (2) generiert und/oder trainiert, welches eine Korrelation zwischen den Bus-Daten (5) und den Strombedarfs-Daten (4) repräsentiert, und
2) Prognostizieren des Energiebedarfs eines Kraftfahrzeugs, indem
- es mit mindestens einem an einem Datenbus des Kraftfahrzeugs angeordneten Datenaufzeichner zum Erfassen von über den Datenbus des Kraftfahrzeugs kommunizierten Bus-Daten (5) bereitgestellt wird,
- mittels dem mindestens einen Datenaufzeichner des Kraftfahrzeugs Bus-Daten (5) des betriebenen Kraftfahrzeugs erfasst und bereitgestellt werden,
- ein gemäß Schritt 1) generiertes und/oder trainiertes künstliches Funktionsmodell (2) am Kraftfahrzeug bereitgestellt und mit den erfassten Bus-Daten (5) versorgt wird,
- wobei das künstliche Funktionsmodell (2) dann nachfolgend als PGS-Daten bezeichnete Prognostizierte-Gesamt-Strombedarf-Daten (7) ermittelt und bereitstellt, welche den prognostizierten Gesamt-Strombedarf des Kraftfahrzeugs oder den prognostizierten Strombedarf einzelner Stromsicherungen und/oder elektrischer Verbraucher des Kraftfahrzeugs repräsentieren,
- wobei die ermittelten Bus-Daten (5) während der Generierung und/oder des Trainierens der Kl (3) gemäß Schritt 1) und/oder während der Prognostizierung des Energiebedarfs eines Kraftfahrzeugs gemäß Schritt 2) dazu genutzt werden, das künstliche Funktionsmodell (2) zu verbessern,
**dadurch gekennzeichnet, dass**
- die ermittelten Bus-Daten (5) nachfolgend als GS-Daten bezeichnete Gesamt-Strombedarf-Daten (6) aufweisen, die den tatsächlichen Gesamt-Strombedarf des Kraftfahrzeugs repräsentieren,
- wobei mittels dem künstlichen Funktionsmodell (2) PGS-Daten (7) bereitgestellt werden,
- wobei die GS-Daten (6) mit den PGS-Daten (7) verglichen werden,
- wobei das künstliche Funktionsmodell (2) dazu eingerichtet ist eine Abweichung (9) zwischen den GS-Daten (6) und den PGS-Daten (7) zu minimieren,
- wobei das künstliche Funktionsmodell (2) eine Minimierung einer Abweichung (9) zwischen den GS-Daten (6) und den PGS-Daten (7) veranlasst, wenn die GS-Daten (6) von den PGS-Daten (7) abweichen.

2. Verfahren (1) nach Anspruch 1,
**dadurch gekennzeichnet, dass**
- die PGS-Daten an einem Steuergerät des Kraftfahrzeugs und/oder einer Entwicklungsumgebung bereitgestellt und/oder dort verwendet werden.

3. Verfahren (1) nach Anspruch 1 oder 2,
**dadurch gekennzeichnet, dass**
- die PGS-Daten eines Kraftfahrzeugs an einem Backend, insbesondere eine vom Kraftfahrzeug entfernte stationäre Stelle, beispielsweise ein Server, bereitgestellt und/oder dort verwendet werden.

4. Verfahren (1) nach einem der vorhergehenden Ansprüche,
**dadurch gekennzeichnet, dass**
das künstliche Funktionsmodell (2) durch ein künstliches neuronales Netz oder ein Regressionsmodell oder ein alternatives Machine-Learning-Modell realisiert ist.

## Claims

1. Method (1) for predicting the energy requirement of a motor vehicle, comprising the following steps:
1) generating and/or training an artificial functional model (2) by means of an artificial intelligence (3), hereinafter referred to as AI, of a motor vehicle model, in that
- the motor vehicle model is provided with measuring sensors arranged on fuses of the motor vehicle model for detecting a power requirement of same and for providing power requirement data (4) representing the detected power requirement, as well as with at least one data recorder arranged on a data bus of the motor vehicle model for detecting bus data (5) communicated via same,
- by means of the measuring sensors, a power requirement is detected at a fuse or at an electrical load and power requirement data (4) representing this detected power requirement are provided,
- by means of the at least one data recorder, bus data (5) are detected and provided,
- the bus data (5) and power requirement data (4) then being time-synchronized and stored in a memory as training data,
- these training data then being provided to the aforementioned Al (3) of the motor vehicle model,
- the Al (3) generates and/or trains an artificial functional model (2) using the provided bus data (5) and power requirement data (4), which functional model represents a correlation between the bus data (5) and the power requirement data (4), and
2) predicting the energy requirement of a motor vehicle, in that
- the motor vehicle is provided with at least one data recorder arranged on a data bus of the motor vehicle for detecting bus data (5) communicated via the data bus of the motor vehicle,
- by means of the at least one data recorder of the motor vehicle, bus data (5) of the operated motor vehicle are detected and provided,
- an artificial functional model (2) generated and/or trained according to step 1) is provided on the motor vehicle and supplied with the detected bus data (5),
- the artificial functional model (2) then determining and providing predicted total power requirement data (7), hereinafter referred to as PTP data, which represent the predicted total power requirement of the motor vehicle or the predicted power requirement of individual fuses and/or electrical loads of the motor vehicle,
- the determined bus data (5) being used during the generation and/or training of the AI (3) according to step 1) and/or during the prediction of the energy requirement of a motor vehicle according to step 2) to improve the artificial functional model (2), **characterized in that**
- the determined bus data (5) contain total power requirement data (6), hereinafter referred to as TP data, which represent the actual total power requirement of the motor vehicle,
- PTP data (7) being provided by means of the artificial functional model (2),
- the TP data (6) being compared with the PTP data (7),
- the artificial functional model (2) being designed to minimize a deviation (9) between the TP data (6) and the PTP data (7),
- the artificial functional model (2) causing a minimization of a deviation (9) between the TP data (6) and the PTP data (7) if the TP data (6) deviate from the PTP data (7).

2. Method (1) according to claim 1,
**characterized in that**
- the PTP data are provided at a control unit of the motor vehicle and/or a development environment and/or are used there.

3. Method (1) according to either claim 1 or claim 2,
**characterized in that**
- the PTP data of a motor vehicle are provided and/or used at a backend, in particular a stationary location remote from the motor vehicle, for example a server.

4. Method (1) according to any of the preceding claims,
**characterized in that**
the artificial functional model (2) is realized by means of an artificial neural network or a regression model or an alternative machine learning model.

## Revendications

1. Procédé (1) pour la prévision du besoin en énergie d'un véhicule automobile, comportant les étapes suivantes :
1) génération et/ou entraînement d'un modèle fonctionnel artificiel (2) au moyen d'une intelligence artificielle (3), appelée ci-après IA, d'un modèle de véhicule automobile, par le fait que
- le modèle de véhicule automobile est mis à disposition avec des capteurs de mesure disposés sur des fusibles de courant du modèle de véhicule automobile pour la détection d'un besoin en courant de ceux-ci et pour la mise à disposition de données de besoin en courant (4) représentant le besoin en courant détecté ainsi qu'avec au moins un enregistreur de données disposé sur un bus de données du modèle de véhicule automobile pour la détection de données de bus (5) communiquées par l'intermédiaire de celui-ci,
- au moyen des capteurs de mesure, un besoin en courant sur un fusible de courant est détecté, ou sur un consommateur électrique, et des données de besoin en courant (4) représentant ledit besoin en courant détecté sont mises à disposition,
- au moyen de l'au moins un enregistreur de données, des données de bus (5) sont détectées et mises à disposition,
- les données de bus (5) et les données de besoin en courant (4) étant alors synchronisées dans le temps et mémorisées dans une mémoire en tant que données d'entraînement,
- lesdites données d'entraînement étant alors mises à la disposition de ladite IA (3) du modèle de véhicule automobile,
- l'IA (3) générant et/ou entraînant, à l'aide des données de bus (5) et des données de besoin en courant (4) mises à disposition, un modèle fonctionnel artificiel (2) qui représente une corrélation entre les données de bus (5) et les données de besoin en courant (4), et
2) prévision du besoin en énergie d'un véhicule automobile par le fait que
- il est mis à disposition avec au moins un enregistreur de données disposé sur un bus de données du véhicule automobile pour la détection de données de bus (5) communiquées par l'intermédiaire du bus de données du véhicule automobile,
- au moyen de l'au moins un enregistreur de données du véhicule automobile, des données de bus (5) du véhicule automobile en service sont détectées et mises à disposition,
- un modèle fonctionnel artificiel (2) généré et/ou entraîné conformément à l'étape 1) est mis à la disposition du véhicule automobile et est alimenté avec les données de bus (5) détectées,
- le modèle fonctionnel artificiel (2) déterminant et mettant ensuite à disposition des données de besoin en courant total prévu (7), appelées ci-après données PGS, qui représentent le besoin en courant total prévu du véhicule automobile ou le besoin en courant prévu de fusibles de courant individuels et/ou de consommateurs électriques du véhicule automobile,
- les données de bus (5) déterminées étant utilisées pendant la génération et/ou l'entraînement de l'IA (3) conformément à l'étape 1) et/ou pendant la prévision du besoin en énergie d'un véhicule automobile conformément à l'étape 2) pour améliorer le modèle fonctionnel artificiel (2), **caractérisé en ce que**
- les données de bus (5) déterminées présentent des données de besoin en courant total (6), appelées ci-après données GS, qui représentent le besoin en courant total effectif du véhicule automobile,
- des données PGS (7) étant mises à disposition au moyen du modèle fonctionnel artificiel (2),
- les données GS (6) étant comparées aux données PGS (7),
- le modèle fonctionnel artificiel (2) étant configuré pour réduire au minimum un écart (9) entre les données GS (6) et les données PGS (7),
- le modèle fonctionnel artificiel (2) provoquant une réduction au minimum d'un écart (9) entre les données GS (6) et les données PGS (7) lorsque les données GS (6) diffèrent des données PGS (7).

2. Procédé (1) selon la revendication 1,
**caractérisé en ce que**
- les données PGS sont mises à la disposition d'un appareil de commande du véhicule automobile et/ou d'un environnement de développement et/ou y sont utilisées.

3. Procédé (1) selon la revendication 1 ou 2,
**caractérisé en ce que**
- les données PGS d'un véhicule automobile sont mises à la disposition d'un programme dorsal, en particulier d'un poste fixe éloigné du véhicule automobile, par exemple un serveur, et/ou y sont utilisées.

4. Procédé (1) selon l'une des revendications précédentes,
**caractérisé en ce que**
le modèle fonctionnel artificiel (2) est réalisé par un réseau neuronal artificiel ou par un modèle de régression ou par un modèle alternatif d'apprentissage machine.
